(19) Europäisches Patentamt
European Patent Office
Office européen des brevets

(11) **EP 3 602 779 B1**

(12) **EUROPEAN PATENT SPECIFICATION**

(45) Date of publication and mention
of the grant of the patent:
**23.07.2025 Bulletin 2025/30**

(21) Application number: **18778052.3**

(22) Date of filing: **26.03.2018**

(51) International Patent Classification (IPC):
**H03F 1/56** (2006.01)   **H03F 3/193** (2006.01)
**H03F 3/217** (2006.01)

(52) Cooperative Patent Classification (CPC):
**H03F 3/2173; H03F 1/565; H03F 3/195;**
**H03F 3/245;** H03F 2200/294; H03F 2200/451

(86) International application number:
**PCT/US2018/024333**

(87) International publication number:
**WO 2018/183189 (04.10.2018 Gazette 2018/40)**

(54) **INTEGRATED SWITCHED-MODE POWER AMPLIFIERS**

INTEGRIERTE SCHALTNETZLEISTUNGSVERSTÄRKER

AMPLIFICATEURS DE PUISSANCE À DÉCOUPAGE INTÉGRÉ

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: **27.03.2017 US 201762477014 P**
**27.03.2017 US 201762477009 P**

(43) Date of publication of application:
**05.02.2020 Bulletin 2020/06**

(73) Proprietor: **Waveguide Corporation**
**Cambridge, MA 02142 (US)**

(72) Inventor: **ALEXEYEV, Alexander**
**Beverly, MA 01915 (US)**

(74) Representative: **Marks & Clerk LLP**
**15 Fetter Lane**
**London EC4A 1BW (GB)**

(56) References cited:
EP-A2- 2 383 893       WO-A1-2008/105592
WO-A2-2006/107815   JP-A- H1 131 952
US-A- 6 087 853       US-A1- 2002 136 326
US-A1- 2005 264 333   US-A1- 2006 214 688
US-A1- 2008 267 280   US-A1- 2012 081 179

US-A1- 2012 214 433   US-A1- 2012 319 883
US-A1- 2014 176 135

• WANG YI-MING ET AL: "Range Unlimited Delay-Interleaving and -Recycling Clock Skew Compensation and Duty-Cycle Correction Circuit", IEEE TRANSACTIONS ON VERY LARGE SCALE INTEGRATION (VLSI) SYSTEMS, IEEE SERVICE CENTER, PISCATAWAY, NJ, USA, vol. 23, no. 5, 1 May 2015 (2015-05-01), pages 856 - 868, XP011579375, ISSN: 1063-8210, [retrieved on 20150422], DOI: 10.1109/TVLSI.2014.2320761
• ROBERT BOGDAN STASZEWSKI ET AL: "RF Amplitude Control in an All-Digital PLL based Transmitter", 1 October 2005 (2005-10-01), XP055672069, Retrieved from the Internet <URL:http://www.bogdanst.com/conference-file/2005-File/2005-10_isocc_rbs_pa_cd.pdf> [retrieved on 20200227]
• DJEMOUAI A ET AL: "New CMOS integrated pulse width modulator for voltage conversion applications", ELECTRONICS, CIRCUITS AND SYSTEMS, 2000. ICECS 2000. THE 7TH IEEE INTE RNATIONAL CONFERENCE ON DEC. 17-20, 2000, PISCATAWAY, NJ, USA,IEEE, vol. 1, 17 December 2000 (2000-12-17), pages 116 - 119, XP010535668, ISBN: 978-0-7803-6542-1

EP 3 602 779 B1

**Description**

CROSS-REFERENCE TO RELATED APPLICATION

This application claims priority to and the benefit of, U.S. Provisional Patent Application Nos. 62/477,009 and 62/477,014, both filed on March 27, 2017.

FIELD OF THE INVENTION

The field of the invention relates, generally, to nuclear magnetic resonance (NMR) equipment, and in particular to managing output impedance and/or power levels in such equipment.

BACKGROUND

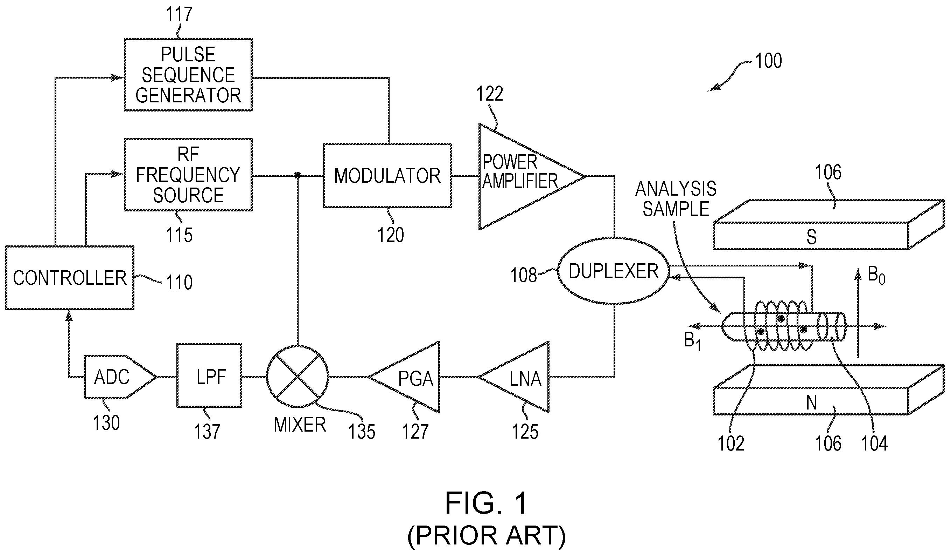

Nuclear magnetic resonance (NMR) is a well-known analytic technique that has been used in a number of fields, such as spectroscopy, bio-sensing and medical imaging. In general, an NMR device includes transceiver circuits to transmit signals to a test sample and receive echo signals therefrom. For example, with reference to FIG. 1, the basic components a conventional NMR system 100 include an NMR coil 102 surrounding a sample 104 being analyzed, a magnet 106 for generating a static magnetic field $B_0$ across the sample 104 and the coil 102, a duplexer 108 coupled to the NMR coil 102, and a controller 110 for controlling operation of the various components. Typically, the duplexer 108 includes a transmitter (Tx) portion for delivering RF signals to the NMR coil 102 and a receiver (Rx) portion for receiving echo signals from the sample 104 vis the NMR coil 102.

NMR coil 102 and transceiver 108 are commonly known as an "NMR probe," which operates with large electromagnets or superconducting permanent magnets in conventional NMR systems. The NMR probe is typically included in an environment having a 50 $\Omega$ impedance because of a long interconnection required between the probe and NMR instrument.

The RF signals delivered by the duplexer 108 originate with an RF frequency source 115 and a pulse sequence generator 117. A modulator circuit 120 modulates the RF signal from the RF frequency source 115 in accordance with the pulse sequence supplied by the pulse sequence generator 117. The modulated RF signal is amplified by a power amplifier 122.

During NMR measurements, the modulated RF signal having a Larmor frequency $\omega_0$ is delivered to the coil 102 via the duplexer 108; the coil 102 generates an RF magnetic field $B_1$ (which is typically orthogonal to the static magnetic field $B_0$) that resonantly excites nuclei spins within the sample 104. After a time duration, $\Delta t$, the RF excitation signal is stopped and the controller 110 causes the duplexer 108 to receive the echo signals from the sample 104. Upon stopping the RF excitation, the nuclear spins within the sample 104 precess around the $B_0$-axis at the Larmor frequency $\omega_0$. The nuclear spins slowly lose phase coherence via spin-spin interactions, which manifest themselves in a macroscopic average as an exponential relaxation or damping signal in the precession of the net magnetic moment. This NMR signal relaxation can be detected by the coil 102. Because the spin-spin interactions are peculiar to the material of the sample 104 being tested, the characteristic time, commonly referred to as $T_2$, of the relaxation signal is material specific.

The duplexer 108 directs the received echo signals, representing the signal output of the NMR probe, to an amplification block including a pre-amplifier (e.g., a low-noise amplifier 125) and a programmable gain amplifier 127. The signal is ultimately converted to digital form by an analog-to-digital converter (ADC) 130 for processing. But the frequency of the "raw" NMR signal received by the pre-amplifier 125 is too high for the ADC 130, and is therefore "down-converted" through comparison with the signal supplied by the RF frequency source 115. A mixer 135 combines the amplified NMR signal, which oscillates at the Larmor frequency, with the reference signal from the RF frequency source to generate a new signal that oscillates at a lower "relative Larmor frequency." Following filtering by a low-pass filter 137, the signal varies slowly enough to be handled by the ADC 130 but nonetheless retains the essential frequency characteristics of the received echo signals.

Thus, by measuring the Larmor frequency $\omega_0$ described above (e.g., for spectroscopy) and characteristic time $T_2$ (e.g., for relaxometry), NMR techniques can be used as an analytic tool in a number of fields, including but not limited to chemical composition analysis, medical imaging, and bio-sensing.

Significant efforts have been devoted to miniaturizing traditional NMR systems. For example, the entire NMR electronics, including the power amplifier (PA) 122, may be integrated on a single semiconductor device. The numerous advantages of miniaturization include low cost, portability, and the fact that a micro-coil tightly surrounding a small sample increases the signal quality. In addition, reducing the size of the magnet 106 allows use of a much smaller power to excite (or polarize) the sample 104 than in a conventional system.

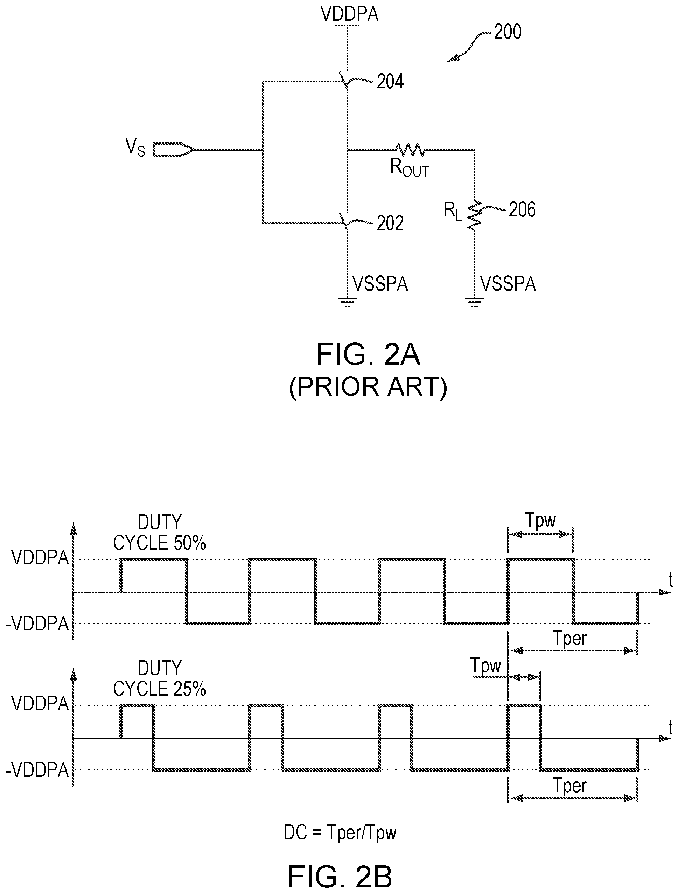

FIG. 2A depicts a traditional class-D PA 200 implemented in a miniaturized NMR system; the input signal $V_S$ to the PA 200 is typically a square-wave signal having low and high amplitudes between the ground ($V_{SSPA}$) and the PA source voltage ($V_{DDPA}$). The input signal is used to close and open switches 202, 204 in an alternating fashion for connecting an output load 206 to either $V_{DDPA}$ or $V_{SSPA}$. The power transferred to the load 206 depends on the output impedance of the amplifier 200, the input signal amplitude $V_S$, and the load impedance $R_L$. In a single-ended PA as depicted in FIG. 2, the delivered power can be represented as:

$$P_L = \frac{1}{2} \frac{|Vs|^2 R_L}{(R_{Out} + R_L)^2} \qquad Eq.\ (1).$$

When the duty cycle of the input switching bipolar square-wave signal is not 50%, the total average power at the fundamental frequency supplied by the PA can be computed as:

$$P_{Av} \cong \frac{\left(\frac{4}{\pi} \times V_{DDPA} \times \sin(\pi \times \text{DUTYCYCLE})\right)^2}{2 \times (2R_{OUT} + R_L)} \qquad Eq.\,(2).$$

where DUTYCYCLE is the positive duty cycle of the waveform expressed as a decimal fraction in the range from 0 to 0.5. Thus, the total average power is a direct function of the supply voltage $V_{DDPA}$, the duty cycle of the input square-wave signals, the output impedance of the PA, and the impedance of the load $R_L$.

The traditional class-D PA typically delivers a power ranging from watts to kilowatts. The power may be adjusted by changing the supply voltage $V_{DDPA}$ while maintaining the duty cycle of the switching waveform at 50% (DUTYCYCLE = 0.5) corresponding to the maximum total average power of the fundamental. In addition, the output impedance $R_{OUT}$ and load impedance $R_L$ are generally kept constant so as to ensure impedance matching between the PA and the load resistor 206.

Recent developments in class-D amplifier technology have been exploited to integrate the PA on a semiconductor device and generate excitation signals suitable for NMR measurements, particularly in low-field time-domain NMR relaxometry. Controlling the available power of the integrated class-D PA via adjustment of the supply voltage, $V_{DDPA}$, however, is not desirable. This is because such adjustment ordinarily requires implementation of an additional power domain and associated pin(s) dedicated exclusively to the PA output drivers; this introduces extra system complexity.

Alternatively, the total available power may be adjusted via changing the duty cycle of the PA switching waveform as shown in FIG. 2B and Eq. (2). In this case a duty cycle control block is inserted between RF signal source 115 and modulator 120 in FIG. 1

Efforts have been made to use analog duty-cycle-control circuits to adjust the duty cycle of the input signals to an integrated PA. Conventional approaches, however, tend to suffer from a high degree of variability and poor control of accuracy when environmental conditions, such as a manufacturing process, supply voltage and operating temperature (PVT) vary. Accordingly, there is a need for an approach that reliably and accurately controls the total available power of the PA by adjusting the duty cycle of the switching input signals. The approach should desirably account for effects resulting from various environmental conditions (e.g., PVT), thereby ensuring repeatably stable power levels during NMR measurements.

In addition, the traditional class-D PA typically has a somewhat limited bandwidth (usually much less than 1 MHz). To make NMR measurements, the PA, however, requires a wide bandwidth (e.g., between 10 MHz and 60 MHz). Further, because the output impedance of the traditional class-D amplifier is fixed, the available power setting is also fixed for the fixed power-supply voltage $V_{DDPA}$. In other words, the power and output impedance of the amplifier are not separable. Because of this constraint, it is difficult to adjust the power available from the amplifier in order to optimize the excitation parameters (such as magnetization flipping angles and NMR excitation pulse spacing) of an NMR measurement. Another challenge of implementing the traditional class-D amplifer in NMR applications is that it is hard to achieve impedance matching (compared to classic audio or power applications) for optimizing the power delivery (as shown by Eq. (1) above) and maintain PA power levels with accuracy and consistency for repeatable NMR measurements.

Various strategies to address these difficulties have been proposed, generally involving the use of discrete components for the PA and assuming the ON resistance of the switches 202, 204 to be negligible. This allows the output impedance of the PA to be set by an external precision resistor. When integrating the PA and other NMR electronics on a single semiconductor device - resulting in an integrated "switch-mode" power amplifier - the switch devices 202, 204 are typically implemented using MOSFETs whose gates are controlled by an input RF signal having a square wave form with an amplitude of $V_{DDPA}$ $V_{SSPA}$.

In a typical NMR application, the PA drives a 50 $\Omega$ load impedance. This means that for the case of a differential class-D PA, each PA driver has an output impedance of 25 $\Omega$ for an optimal, reflection-free power delivery to the load. The ON resistance of the MOS device, however, varies with manufacturing processes, supply voltage and temperature. In addition, the highly nonlinear behavior for large voltages across the device makes it extremely challenging to implement a basic MOSFET switch having a constant ON resistance of 25 Ω.

Accordingly, there is a need for an approach that reduces the variability of the output impedance of an integrated switch-mode power amplifier in order to maintain consistent power levels repeatably during NMR measurements.

US 2012/0214433 relates to a transmitter with class E amplifier. JP H11 031952 relates to a clock synchronisation delay circuit. EP 2383893 A2 relates to an integrated circuit including a digitally-controlled power generation stage comprising a plurality of selectable switching devices capable of adjusting an envelope of the radio frequency carrier, and a pulse width modulator generator arranged to generate a pulse width modulator control signal. The pulse width modulator generator inputs the control signal to a subset of the plurality of the selectable switching devices to adjust the envelope radio frequency carrier output from the digitally-controlled power generation stage.

SUMMARY

In accordance with the invention there is provided: circuitry for adjusting a duty cycle of an RF carrier input signal to a power amplifier, as recited by claim 1; and an NMR apparatus as recited by claim 9.

Also disclosed herein, but not claimed, is an approach for reducing variability in the output impedance of an integrated switch-mode power amplifier by splitting the output impedance between passive resistor, which may be on-chip, and a MOSFET switch of the amplifier. The PA may have a single-ended configuration or a differential configuration having two single-ended structures operating with opposite phases. In one implementation, the size of the MOSFET switch is larger than that of the MOSFET switch implemented in a conventional PA, but the size is still acceptable to operate the PA at a desired frequency. In addition, a calibration approach may be utilized to ensure that the MOSFET switch has a controlled and calibrated ON resistance, thereby providing stable output power levels of the PA and ensuring consistency and repeatability in NMR measurements.

In an implementation of circuity for reducing variability in the output impedance, a replica circuit of a class-D PA-driver sensor is utilized to monitor the output impedance of the matched replica switch devices; a software (and/or hardware) implemented state-machine algorithm may then be utilized to automatically adjust the output impedance of the PA to achieve a target value set by a pair of externally matched precision resistors. Implementation of the resistor on-chip may advantageously eliminate the need for an external resistor component and, at the same time, reduce voltage swings across the MOSFET switch device, thereby increasing the linearity thereof.

The present invention generally relates to an approach for accurately setting a duty cycle of PA switching waveforms, and may be implemented using an all-digital PVT sensor circuit. In various implementations, the all-digital PVT sensor circuit measures a pulse width of a periodic reference signal using digital delay line, and subsequently, implements an off-chip digital calculation to program the digital delay line to delay this periodic reference signal so that, when the delayed periodic reference signal is combined with the original (undelayed) reference via a logical AND operation, the resulting signal conforms to a desired duty cycle. In one implementation, the PA is a class-D PA, which may have a single-ended configuration or a differential configuration having two single-ended structures operating in opposite phases.

Also disclosed herein, but not claimed, is circuitry for reducing variability of an output impedance of an integrated switch-mode PA. The circuitry may comprise a PA driver; a pre-driver for facilitating activation and deactivation of the PA driver; and a passive resistor coupled to the PA driver so as to split the output impedance between the PA driver and the passive resistor. The PA driver may comprise or consist of a PMOS device and an NMOS device. Typically, the on-chip passive resistor has an impedance that substantially does not depend on temperature or voltage.

The circuitry reducing variability of an output impedance may further comprise a calibration circuit for calibrating an ON resistance of the PA driver so as to provide stable output power levels. The calibration circuit may comprise a replica circuit of the PA driver and a load resistor, and may further comprise an on-chip voltage divider for generating a reference voltage. The calibration circuit may further comprise a comparator for comparing the reference voltage with an output voltage of the replica circuit and the load resistor. The passive resistor may be on-chip or off-chip.

Also disclosed herein, but not claimed, is an NMR apparatus comprising an NMR coil configured to enclose a sample, an integrated switch-mode PA coupled to the NMR coil, and circuitry for reducing variability of an output impedance of the PA. The circuitry may include (i) a PA driver, (ii) a pre-driver for facilitating activation and deactivation of the PA driver; and (iii) an on-chip passive resistor coupled to the PA driver for splitting the output impedance between the PA driver and the passive resistor. The circuitry may include one or more of the features described above.

Also disclosed herein, but not claimed, is a method of reducing variability of an output impedance of an integrated switch-mode PA. The method may comprise providing a PA driver having at least one MOS device; providing a pre-driver for facilitating activation and deactivation of the PA driver; and adjusting the number of stripes of the MOS device(s) so to provide a desired impedance.

The invention pertains to circuitry for adjusting a duty cycle of an RF carrier input signal to a PA as defined in claim 1.

In various embodiments, the circuitry further comprises a processor having a register for bypassing the digital delay line. Each one of the delay elements may comprise one input and three outputs. For example, a first one of the outputs may be coupled to an input of a successive delay element; a second one of the outputs to an input of a multiplexer; and a third one of the outputs to an input of the time-to-digital converter.

In accordance with the invention, the circuitry further comprises a processor configured to determine the number of the delay elements required for generating the desired duty cycle based on a measurement of the time-to-digital converter. The processor may be implemented on a chip integrating the digital delay line and time-to-digital converter, or off a chip integrating the digital delay line and time-to-digital converter; in the latter case, the circuitry may further comprise a communication module for allowing signal communication between the processor and the chip.

Another aspect of the invention relates to an NMR apparatus comprising an NMR coil configured to enclose a sample; an integrated switch-mode PA coupled to the NMR coil; and circuitry for adjusting a duty cycle of an input signal to a power amplifier (PA) as described above.

In general, as used herein, the term "substantially" means $\pm 10\%$, and in some embodiments, $\pm 5\%$. In addition, reference throughout this specification to "one example," "an example," "one embodiment," or "an embodiment" means that a particular feature, structure, or characteristic described in connection with the example is included in at least one example of the present technology. Thus, the occurrences of the phrases "in one example," "in an example," "one embodiment," or "an embodiment" in various places throughout this specification are not necessarily all referring to the same example. Furthermore, the particular features, structures, routines, steps, or characteristics may be combined in any suitable manner in one or more examples of the technology. The headings provided herein are for convenience only and are not intended to limit or interpret the scope or meaning of the claimed technology.

BRIEF DESCRIPTION OF THE DRAWINGS

In the drawings, like reference characters generally refer to the same parts throughout the different views. Also, the drawings are not necessarily to scale, with an emphasis instead generally being placed upon illustrating the principles of the invention. In the following description, various embodiments of the present invention are described with reference to the following drawings, in which:

FIG. 1 schematically illustrates a conventional NMR device.

FIG. 2A schematically illustrates a conventional class-D power amplifier.

FIG. 2B is a timing diagram illustrating the definition of duty cycle.

FIG. 3A schematically illustrates a circuit comprising an exemplary class-D PA interface coupled to an NMR probe.

FIG. 3B schematically illustrates an exemplary circuit for adjusting ON resistance.

FIG. 4 schematically illustrates a calibration circuit.

FIG. 5 is a flow chart illustrating a representative approach for calibrating PA output impedance.

FIG. 6A schematically illustrates the relationship between the duty-cycle controller shown in FIG. 6B and other components of an NMR system.

FIG. 6B schematically illustrates an exemplary circuit for duty-cycle control.

FIG. 6C schematically illustrates generation of quadrature phase inputs to the duty-cycle controller shown in FIG. 6B.

FIG. 7 schematically illustrates, in greater detail, a time-to-digital converter in accordance with embodiments of the invention.

FIG. 8 is a timing diagram.

DETAILED DESCRIPTION

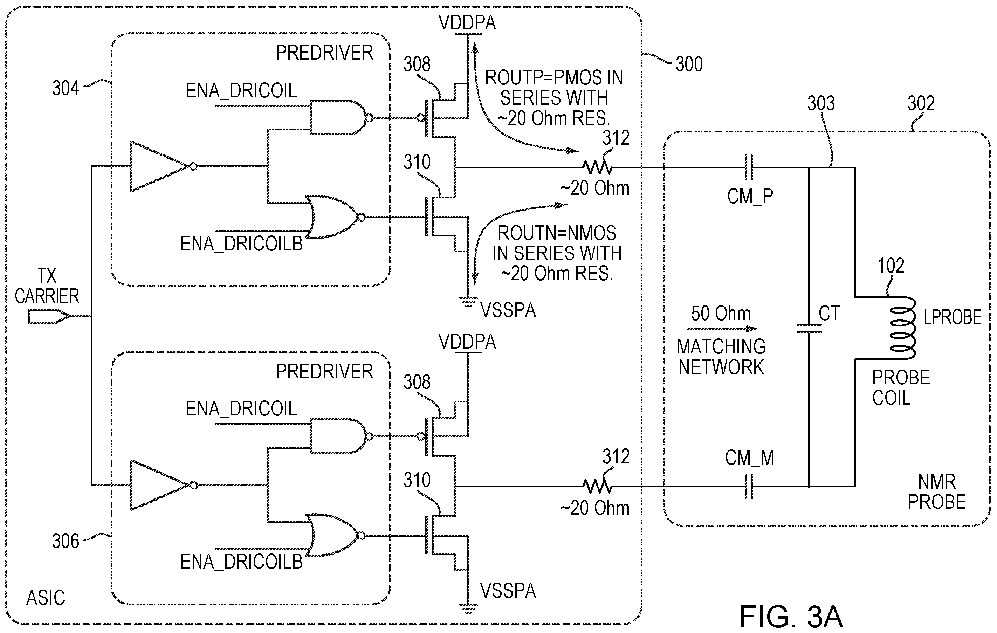

Refer first to FIG. 3A, which depicts an exemplary differential class-D PA interface 300 coupled to an NMR probe 302. The PA is implemented as a part of a CMOS (Complementary Metal Oxide Semiconductor) application-specific integrated circuit (ASIC) chip. The NMR probe 302 includes a coil 102 and capacitors CM_P, CM_M, CT. Capacitor CT in combination with inductance of coil 102 creates a parallel resonant circuit 303. Capacitor CM_P and CM_M provide a matching network that transforms the impedance of parallel resonant circuit 303 to the passive differential impedance $R_T$ at the excitation frequency at the output of the PA. The PA 300 is implemented as a discrete chip or a part of a larger application specific integrated circuit (ASIC) including a pair of pre-drivers 304, 306, each coupled to output driver P-type and N-type MOSFET devices 308, 310, which are connected in series with an on-chip resistor 312 having a resistance $R_D$ and function as the PA circuit. The pre-drivers 304, 306 receive, respectively, the pulse sequence, its inverse and the carrier signal, and include logical NAND and NOR gates. In a typical switched-mode power amplifier, the sizes of the PMOS device 308 and NMOS device 310 are chosen to produce a desired PA output power for operation at a target frequency. A fundamental tradeoff exists between the amount of power provided by such PA and its bandwidth due to the parasitic capacitances of devices 308, 310, which reduce the PA bandwidth as their sizes are increased to boost output PA power and vice versa.

In CMOS manufacturing process, ON resistances ($R_{ON}$) - i.e., the resistance across the drain/source path of the MOSFET with the gate terminal configured to operate the MOSFET in a strong inversion linear regime - is a function of many parameters, such as supply voltage, operating temperature, variations in manufacturing parameters including lithography, chemical etching, and electron mobility (among others). As a result, a switching-mode power amplifier using MOSFET devices 308, 310 as switches in the in configuration shown in FIG. 3A will exhibit a large variation of up to 30% in both output power and bandwidth due to variation in the MOSFET ON resistance from one instance of circuit 300 to another and over the full range of environmental conditions. To minimize this variation a calibration approach, as further described below, is utilized to adjust the ON resistance of the PMOS device 308 and NMOS device 310 and keep it at a constant value suited to the particular application.

Because the devices 308, 310 are each connected in series with the resistor 312, the target ON resistance of devices 308, 310 is $R_{ON}$ $\Omega$ so as to provide a combined differential PA output impedance of $R_T = 2 \times (R_{ON} + R_D)$. In a typical NMR instrument, NMR probe 302 presents a passive 50 $\Omega$ load to the PA that is expected to have an output impedance of the same value. This promotes optimal power delivery from the PA to probe 302 and avoids electrical reflections that can damage the PA. Without loss of generality, other interface impedance values can be chosen; for example, smaller interface impedance values will result in larger power delivery by the PA. In this case, the value of resistor 312 is reduced and the values of matching capacitors CM_P, CM_M are adjusted appropriately to satisfy the power-matching condition and the lower interface impedance.

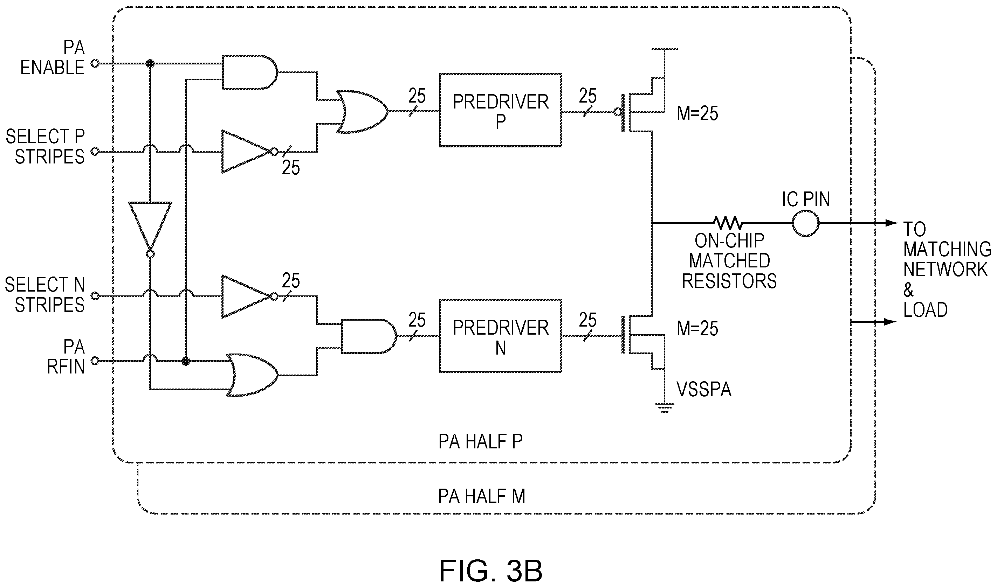

FIG. 3B illustrates a circuit for adjusting the ON resistance by changing the total width of the output MOSFET devices 308, 310 driving the output of the PA. In one example, PA output devices are configured as a parallel connection of plurality of MOSFET devices ("stripes") each having a width equal to the total desired width of the MOSFET device divided by the chosen number of parallel devices. Without loss of generality, in the example shown in FIG. 3B, the number of parallel MOSFET devices is indicated as NSTRIPES. In some examples, the number of stripes in PMOSFET devices can differ from the number of stripes in NMOSFET devices to accommodate different variabilities of P-type and N-type MOSFETs. Unlike the conventional class-D PA illustrated in FIG. 3A, the gate terminals of the output MOSFETS shown in FIG. 3B can be individually controlled using the illustrated stripe-selection logic circuits 320, 322. In particular, the desired number of stripes is selected by driving HI the appropriate number of bits in the digital control signals SELECT_P_STRIPES and SELECT_N_STRIPES, which are digital signals of width NSTRIPES bits. The value of NSTRIPES is chosen in such that when all stripes of the output MOSFET device are selected, the ON resistance of the MOSFET device is less than the target RON value for the worst-case manufacturing variation, resulting in lowest ON resistance of the typical MOSFET in the chosen manufacturing process, lowest desired operating temperature and highest operating power supply voltage.

The resistance $R_D$ of the on-chip resistors 312 typically does not depend significantly on temperature and voltage, but may vary in a range of $\pm 15\%$ as a result of the manufacturing process variations. Thus, total single-ended output impedance of the PA, $R_{ON} + R_D$, may vary in the range of $\pm 30\%$; this necessitates a calibration approach to provide stable PA output power levels to ensure consistency and repeatability during NMR measurements.

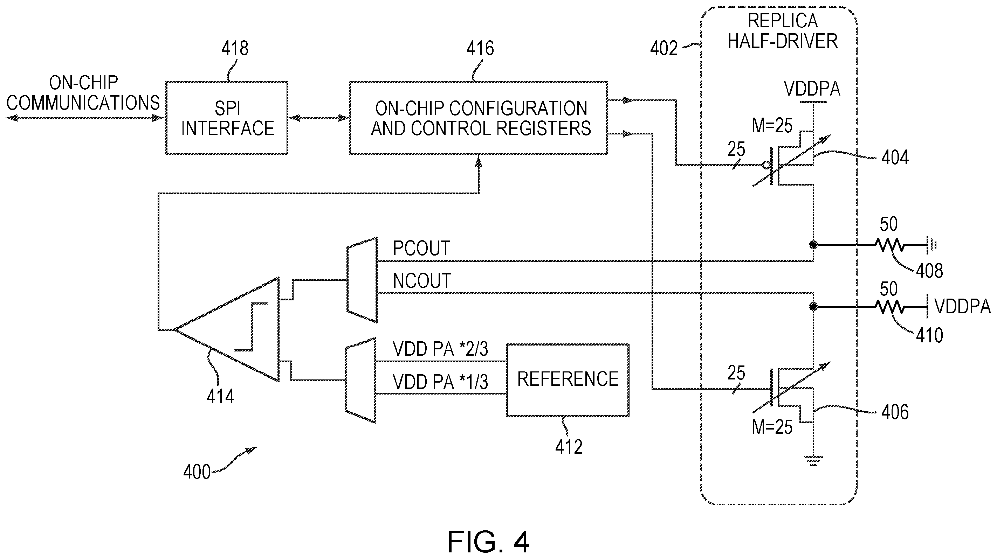

FIG. 4 illustrates a calibration circuit 400. The calibration circuit 400 utilizes sensors integrated on the same chip as the PA circuit 300 to accurately measure a DC ON resistance of the switch MOSFET devices of the PA. In various examples, the ON resistance is measured using a PA driver replica circuit 402 having PMOSFET and NMOSFET switches 404, 406 with on-chip resistors $R_D$ and loaded with external resistors 408, 410, respectively; each of the resistors 408, 410 has an impedance of $R_{CAL}$ precisely. Devices 404, 406 have identical total width and length and have the same number of stripes (NSTRIPES) as devices 308, 310 shown in FIG. 3A. In various examples, the calibration approach implements an on-chip voltage reference 412 for generating a reference voltage and a comparator 414 for comparing the reference voltage with the output voltage of the sense PMOSFET or NMOSFET 404, 406 generated by a resistive divider from $V_{DDPA}$ to $V_{SSPA}$. The resistive dividers may be formed by the resistors 408, 410, which have a precise impedance of $R_{CAL}$, resistors $R_D$ connected in series with the drain terminal of the PMOSFET and NMOSFET sensors of the calibration circuit, and the ON resistance of the MOSFET devices 404, 406.

In various examples, a decision value of the comparator 414 is stored in one of a bank of control registers 416, which are accessible to a digital interface 418. (All of these components may reside on the ASIC 300 shown in FIG. 3A.) In addition, a finite state machine may be utilized to adjust the corresponding ON resistance of the replica half driver 402 until the output voltage of the sense PMOSFET or NMOSFET crosses a threshold voltage corresponding to a target value of the ON resistance. For the PMOSFET sensor circuit, the comparator threshold voltage is chosen to be $(2/3) \times V_{DDPA}$ where $V_{DDPA}$ is the PA supply voltage. For the NMOSFET sensor circuit, comparator threshold voltage is chosen to be $(1/3) \times V_{DDPA}$. The finite state machine may be implemented on or outside the chip 300 in hardware and/or software. In some examples, the threshold voltages can be generated internally on the chip using the resistive divider string formed by three identical resistors connected in series from $V_{DDPA}$ to $V_{SSPA}$. Given the generated threshold voltages, the comparator output will change when the following condition is met for either one of the MOSFET sensors: $R_{ON} + R_D = (R_{CAL}/2)$.

In various examples, the PA half-replica impedance sensor 402 is controlled by two control registers (e.g., CENSN and CENSP in a Model WG1000 provided by WaveGuide Corporation). Writing logic 1 to either one of these registers may enable one or both sense devices 404, 406. In addition, two registers (e.g., CDSN and CDSP) may be used to drive the gates of the MOS sensor devices 404, 406 to an appropriate value required for the calibration approach. In some examples, a register (e.g., SELCALREF) is used to select which one of the sense PMOSFET and NMOSFET devices and which reference voltages are connected to the inputs of the decision comparator 414. For example, writing logic 0 may select the output from the sense PMOS 404 and $(2/3) \times V_{DDPA}$ reference voltage, whereas writing logic 1 may select the output from the sense NMOS 406 and $(1/3) \times V_{DDPA}$ reference voltage.

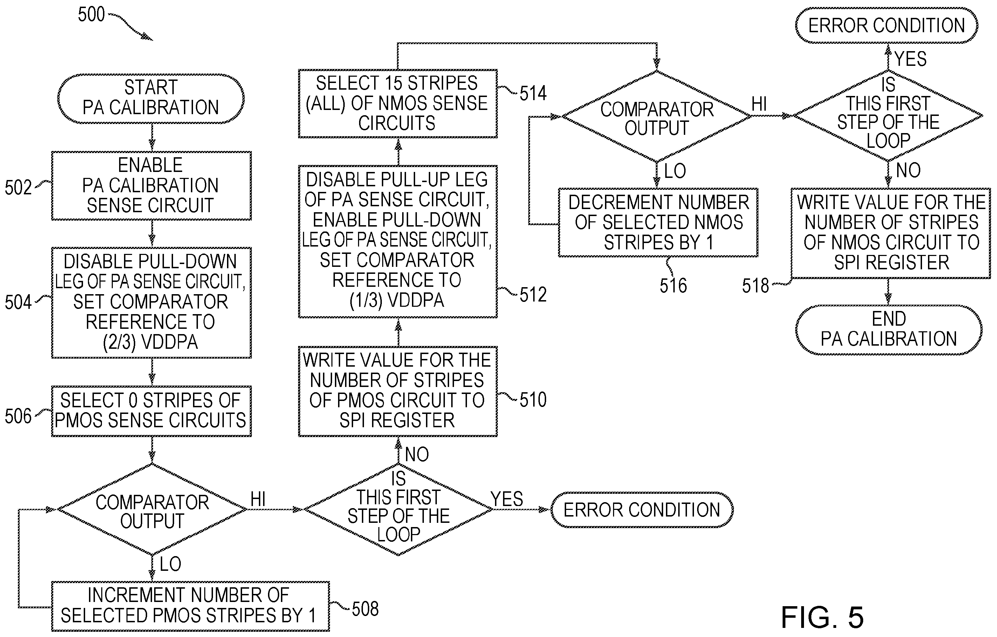

FIG. 5 illustrates a representative flow chart 500 illustrating operation of the calibration circuit 400 for calibrating a PA output impedance. In an example, the output impedance of the PA is calibrated, before each NMR experiment, during the so called "recycle delay" or after the chip is powered up. While no specific algorithm update rate is specified for the steps of the flow chart 500, it is expected that a minimal progression time interval in the finite state machine is determined based on the settling time constants of capacitors in a low-pass filter that are used to remove high-frequency noise at the inputs of the decision comparator 414 arising during switching between different comparison thresholds.

With reference to FIGS. 3B, 4 and 5, in a first step 502, the circuit 400 is enabled. The NMOSFET leg 406 of the circuit 400 is disabled and the comparator reference 412 is set to $(2/3) \times V_{DDPA}$ reference voltage (step 504). At this point, no stripes of the PMOSFET sense circuit 404 are selected (step 506). If the output of the comparator 414 is low, additional stripe is enabled in the PMOSFET sense circuit 404 (step 508). If the output of the comparator 414 is high and the procedure 500 has just been entered, an error condition exists where either target $R_{ON}$ value of the PMOSFET device is too large and cannot be achieved by selecting even single stripe of the calibration sensor PMOSFET 404 or comparator threshold value was chosen incorrectly for the target $R_{ON}$ value; otherwise, the current number of stripes is written the register bank 416 (step 510). At this point the PMOSFET leg 404 of the circuit 400 is disabled and the NMOSFET leg 406 is enabled, and the comparator reference 412 is set to $(1/3) \times V_{DDPA}$ reference voltage (step 512). All 15 stripes of the NMOS sense circuit are selected (step 514). If the output of the comparator 414 is now low, the number of stripes selected for the NMOS sense circuit is progressively decremented until the comparator output is high (step 516). Once again, if the comparator output is high and the procedure 500 has just been entered, an error condition exists where either target $R_{ON}$ value of the NMOSFET device is too small (i.e., cannot be achieved by selecting all stripes of the calibration sense NMOSFET 406) or the comparator threshold value was chosen incorrectly for the target $R_{ON}$ value; otherwise, the current number of stripes is written the register bank 416 (step 518) and the procedure ends. The target value of the ON resistances having thus been established and set, the NMR circuit is ready for operation.

The calibration method 500 may be implemented in the controller 110. Controller 110 may be implemented in hardware, software or a combination of the two. For implementations in which the functions of the controller are provided as one or more software programs, the programs may be written in any of a number of high level languages such as PYTHON, PASCAL, JAVA, C, C++, C#, BASIC, various scripting languages, and/or HTML. Additionally, the software can be implemented in an assembly language directed to the microprocessor resident on a target computer; for example, the software may be implemented in Intel 80x86 assembly language if it is configured to run on an IBM PC or PC clone. The software may be embodied on an article of manufacture including, but not limited to, a floppy disk, a jump drive, a hard disk, an optical disk, a magnetic tape, a PROM, an EPROM, EEPROM, field-programmable gate array, or CD-ROM. Implementations using hardware circuitry may be implemented using, for example, one or more FPGA, CPLD or ASIC processors. Controller 110 may be implemented in hardware, software or a combination of the two. For implementations in which the functions are provided as one or more software programs, the programs may be written in any of a number of high level languages such as PYTHON, PASCAL, JAVA, C, C++, C#, BASIC, various scripting languages, and/or HTML. Additionally, the software can be implemented in an assembly language directed to the microprocessor resident on a target computer; for example, the software may be implemented in Intel 80x86 assembly language if it is configured to run on an IBM PC or PC clone. The software may be embodied on an article of manufacture including, but not limited to, a floppy disk, a jump drive, a hard disk, an optical disk, a magnetic tape, a PROM, an EPROM, EEPROM, field-programmable gate array, or CD-ROM. Implementations using hardware circuitry may be implemented using, for example, one or more FPGA, CPLD or ASIC processors.

Approaches described herein may be particularly suitable for implementation in a low-field NMR system where multiple transceivers are integrated on the same semiconductor substrate such that multiple simultaneous NMR measurements can be performed at once. A single replica half circuit described above may be used to independently calibrate all on-chip PAs without the need for providing numerous external resistors to match the impedance of each individual PA.

In addition, approaches described herein may be suitable for implementation in a low-field NMR system where an NMR coil is integrated on the same silicon substrate as the NMR transceiver, or on a separate silicon substrate but is encapsulated in the same package. In this situation, the calibration techniques described herein may provide precise and robust power delivery to the NMR coil without directly accessing and configuring the interface between the PA and NMR coil.

An additional benefit is that this technique may also allow class-D PAs to be used with NMR probes having a significantly lower impedance. The ability to precisely control the output impedance at lower absolute impedance values is important because the same absolute variations of PA output impedance may result in larger relative variations of the delivered output power. In micro-NMR, it is desirable to shift from a 50 $\Omega$ system to a lower-impedance system so as to increase the total available PA and delivered power for the same supply voltage $V_{DDPA}$.

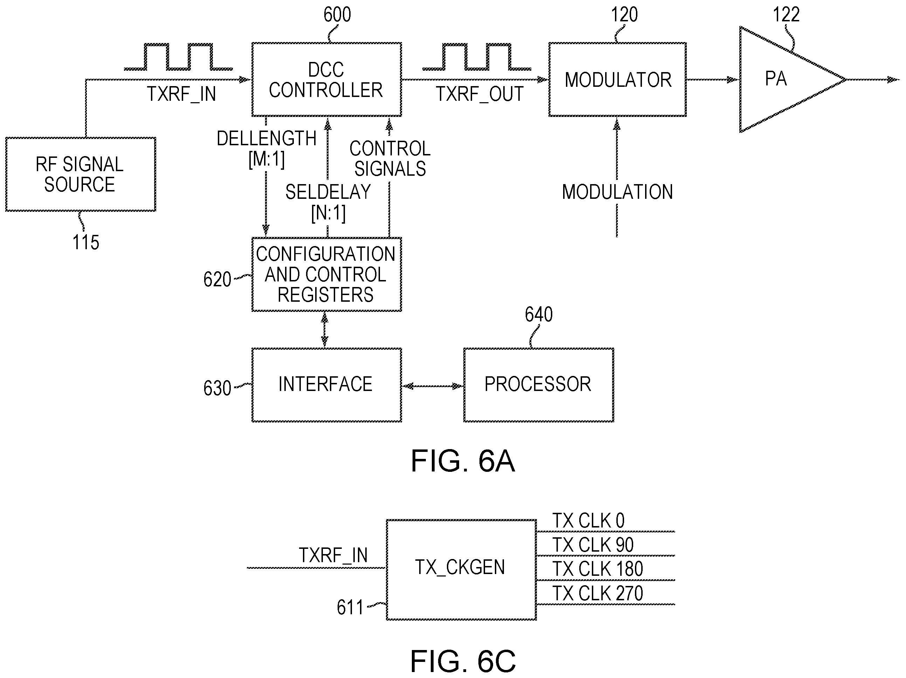

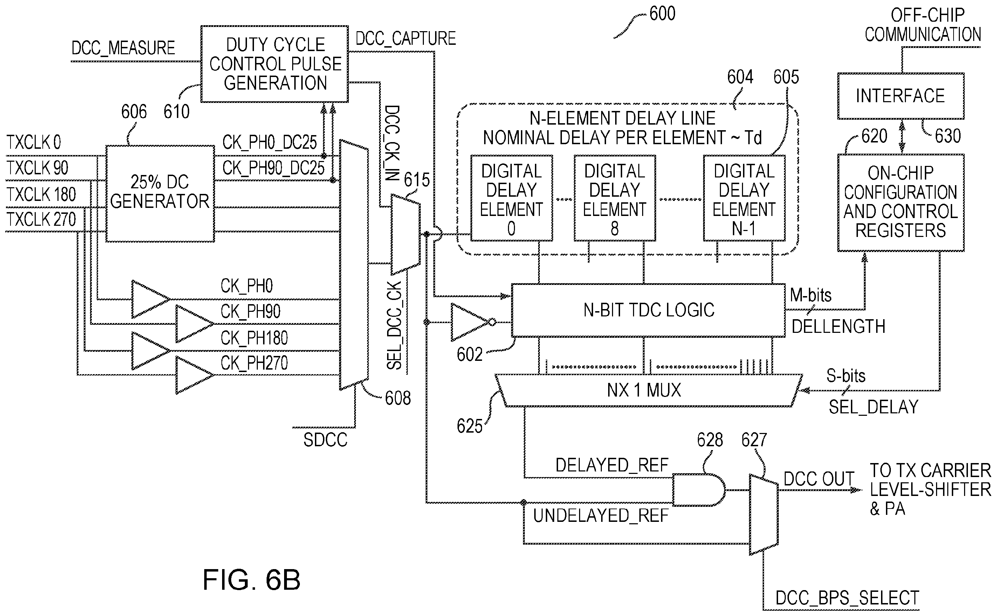

In various embodiments, with reference to FIGS. 6A and 6B, duty-cycle-control (DCC) circuitry 600 may be implemented to reliably and accurately set a duty cycle of PA switching waveforms so as to control the total available power of the PA. The DCC circuitry 600 includes two main components: a time-to-digital converter logic (TDC LOGIC) block 602 and a digital delay line (DDL) 604. Together, block 602 and DDL 604 form a time-to-digital converter (TDC). DDL 604 includes N digital-delay elements 605 connected in series, where the output of each delay element is connected to the input of the next delay element and is also connected to one of the inputs of the TDC LOGIC block 602. The total number of delay elements N and the delay Td through each individual delay element 605 of the DDL are chosen to ensure that under all PVT conditions, DDL will provide an accurate measurement of 1/4 of the TX carrier period (in units of Td) with the resolution required for a desired accuracy of duty-cycle programming. The TDC is a sensor that measures the number of delay elements 605 in the DDL 604 required to delay the rising edge of the input TX carrier signal TXRF_IN with a 50% duty cycle by 1/4 of the period of the TX carrier signal (which corresponds to the output of the RF frequency source 115 shown in FIG. 1 and labeled TXRF_IN in FIG. 6A).

This number of delay elements, designated as DNUMTXCK, represents the measurement of 1/4 of the TX_carrier period in units of Td and is used to compute the required number of delay-line elements 605 for generating a DCC_OUT (indicated as TXRF_OUT signal in FIG. 6A) signal with a specific duty cycle as a fraction of DNUMTXCK. This signal is provided to the modulator 120 as the duty-cycle-controlled RF frequency source. The value of DNUMTXCK is always less than or equal to the total number of delay elements N.

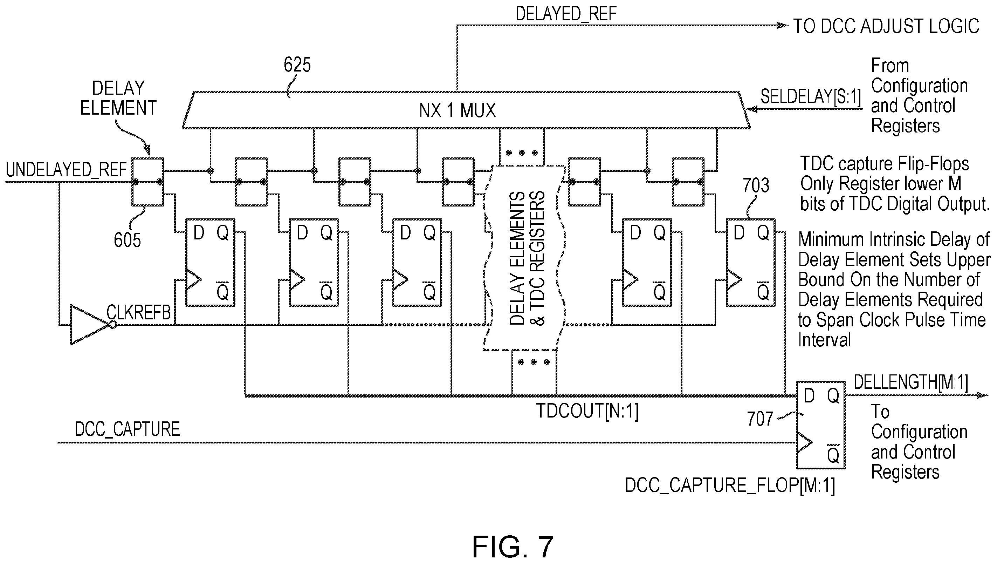

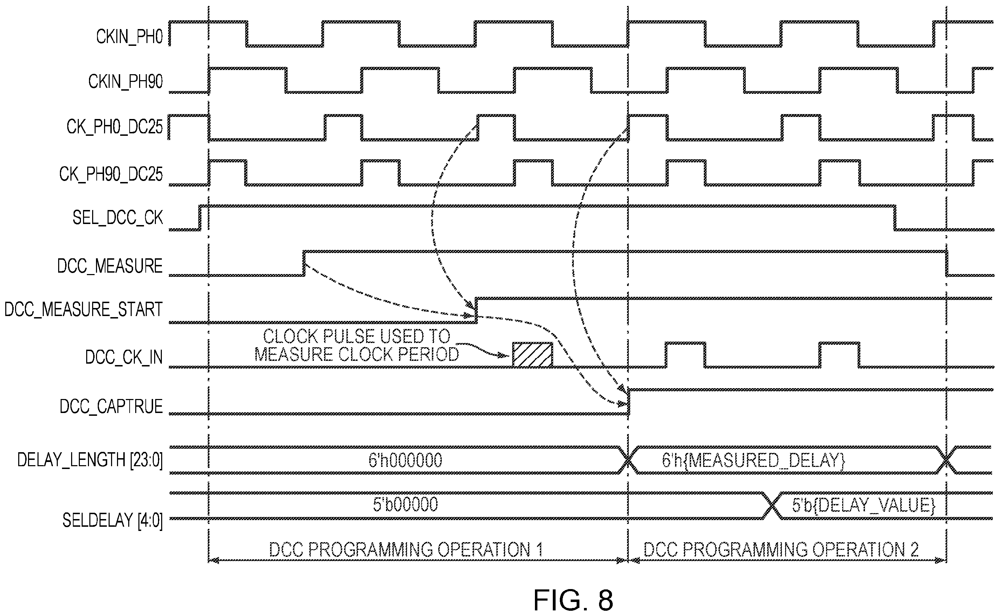

With reference to FIGS. 6A-6C and 7, programming the duty cycle of the DCC_OUT signal involves two sequential operations as shown in FIG. 8. First, the TDC circuit comprising the DDL 604 and the TDC LOGIC block 602 measures the TX carrier period, expressed as the closest integer number DNUMTXCK, of the delays Td required to span exactly 1/4 of the TX carrier clock period. And second, the target duty cycle of DCC_OUT is programmed by selecting the required number of delays Td - i.e., DNUMDCC - in the DDL 604 to represent the desired duty cycle of the signal DCC_OUT after the delayed signal DELAYED_REF is combined with signal UNDELAYED_REF via a logical AND operation as shown in FIG. 6B.

In various embodiments, in order to reduce the length of the DDL 604 and the TDC LOGIC block 602 required to measure the period of the TX carrier signal, the DCC circuitry 600 uses an input clock pulse having a duration of exactly 1/4 of the period of TXRF_IN. This clock pulse corresponds to a 25% duty cycle of the TXRF_IN signal and can be generated by performing logic operations on the quadrature phases of the input clock TXRF_IN. In particular, quadrature components TX_CLK0, TX_CLK90, TX_CLK180 and TX_CLK270 of the clock signal TXRF_IN are generated by block TX_CKGEN (as shown in FIG. 6C) placed at the output of the RF frequency source 115. The quadrature components TX_CK0, TX_CK90, TX_CK180 and TX_CK270 are then provided to a 25% duty cycle generator (DCG) 606 that generates 25% duty cycle waveforms of the quadrature phases of the input signal TXRF_IN. Multiplexer 608 is then used to select between the quadrature phases of TXRF_IN that have a 50% and a 25% duty cycle.

The DCC circuitry 600 may have a HIGH-power mode and a LOW-power mode corresponding to the 50% and 25% duty cycle of the output signal DCC_OUT. These modes are accessible via an internal configuration and/or control registers 620. Specifically, when an internal register corresponding to the multiplexer 608 select signal SDCC is written HI, a low-power mode is enabled by selecting one of the quadrature components of the signal TXRF_IN with the 25% duty cycle to propagate through to the input of the modulator 120. Alternatively, when signal SDCC is driven LOW, one of the 50% duty cycle quadrature components of signal RF_CLKIN will propagate to the input of the modulator 120.

A second multiplexer 615 is employed during the first operation of the duty cycle programming. It is used to select a single 25% duty cycle clock pulse of the RF_CLKIN signal with quadrature phase 90 degrees to perform TDC measurements. The signals and sequence of logic operations during the first operation (TDC measurement) are shown in FIG. 8. Prior to the TDC measurement signals SEL_DCC_CK, DCC_MEASURE, DCC_MEASURE_START, DCC_CK_IN, DCC_CAPTURE - also labeled CONTROL SIGNALS in FIG. 6A - are driven LOW by resetting all associated configuration registers that are used to control these signals via a digital interface. To initiate TDC measurement, signal SEL_DCC_CK is driven HIGH by writing to the associated control register to select DCC_CKIN input of the multiplexer 615 to propagate to the DDL 604 and TDC LOGIC 602. When the signal DCC_MEASURE is asserted HIGH by writing corresponding internal register, duty cycle control/pulse generation block 610 drives HIGH the signal DCC_MEASURE START on the second detected rising edge of the signal CK_PH0_DC25. The rising edge of the signal DCC_MEASURE START then enables propagation of the signal CK_PH0_DC25 to the output DCC_CK_IN of the block 610 to the DLL 604 and TDC LOGIC BLOCK 602. Consequently, the DCC_CAPTRUE signal is driven HIGH on the third detected rising edge of the signal CK_PH0_DC25 to capture TDC measurement results, TDCOUT, in capture registers 707 (see FIG. 7) as a digital word DELLENGTH of length M bits, where M is equal or less than the length N of the DDL. At this point, the signal SEL_DCC_CK is driven LOW by writing the corresponding control register in block 620. This disables DCC pulse generation block 610 and completes first operation in the DCC programming sequence. It should be noted that the timing between steps in the sequence of operations may not be critical and thus may be set based on application requirements.

The signal DELLENGTH is a temperature-encoded measurement of exactly 1/4 of the TXRF_IN carrier period with the number of non-zero least-significant bits corresponding to the number DNUMTXCK. In some embodiments, the DCC circuitry 600 may be bypassed by writing 1 into a DCC _BPS_SELECT register of block 620 and selecting bypassing input to the multiplexer 627. The DCC_BPS_SELECT register may have a default state set as 0.

Block 620 communicates with the interface block 630, which implements an off-chip communications protocol and the physical layer. The interface block 630, in turn, communicates with the processor block 640. The processor block 640 includes a conventional central processing unit, memory, and control registers, and may be implemented on a chip integrating various parts of the DCC circuitry 600 or off the chip as an external device.

In the second operation of duty cycle programming sequence, the lower M bits of the TDC 602 output TDCOUT are written into the register block 620 as signal DELLENGTH, and are forwarded to the processor block 640 via the interface 630. The processor block 640 is a priori provided with information about the desired duty cycle value (DCTARGET), which it stores in an internal memory device. Based on that stored value and the information provided by signal DELLLENGTH, the processor block 640 computes the required number of delay elements to generate signal DELAYED_REF. This signal, in turn, is used to generate the output signal DCC_OUT with the target duty cycle by performing logic AND operation on the signals DELAYED_REF and UNDELAYED _REF. The required number of delay elements is binary-encoded and written to the register block 620 as the signal SELDELAY of length S via interface 630. The multiplexer 625 then decodes binary signal SELDELAY and selects the output of the appropriate delay line element to generate signal DELAYED_REF. The output DCC_OUT of the multiplexer 625 is TXRF_OUT, the carrier signal of the DCC controller 600 with the target duty cycle value. The DCC controller 600 produces the TXRF_OUT carrier signal with duty cycle that is greater than zero and less than or equal to 50%. For applications where lower jitter and low phase noise are required, a "clean" 50% or 25% duty cycle waveform is obtained by bypassing DDL and AND gate 628 by writing 1 in register DCC _BPS_SELECT as shown in FIG. 6B.

In various embodiments, for a target duty cycle having a value between 0% and 25%, signal SDCC is driven HIGH to select one of the 25% duty cycle quadrature phases to propagate to the output of the multiplexer 615, DDL 604, multiplexer 625 and AND gate 628. The number DNUMDCC of required selected delay elements of DDL for the DCTARGET value is expressed as:

$$\mathrm{DNUMDCC} = \mathrm{floor}\left(\mathrm{DNUMTXCK} \cdot \left(1 - 4 \cdot \left(\frac{\mathrm{DCTARGET}}{100}\right)\right)\right) \qquad Eq.\,(3).$$

For a target duty cycle having a value between 25% and 50%, the signal DCC is driven LOW to select one of the 50% duty cycle quadrature phases to propagate to the output of the multiplexer 615, DDL 604, multiplexer 625 and AND gate 628. The corresponding computation for number DNUMDCC is expressed as:

$$\mathrm{DNUMDCC} = \mathrm{floor}\left(\mathrm{DNUMTXCK} \cdot \left(1 - 4 \cdot \frac{\mathrm{DCTARGET} - 0.25}{100}\right)\right) \qquad Eq.\,(4).$$

FIG. 7 illustrates the TDC 602 and support circuitry in greater detail. Each delay element 605 in the DDL 604 may have one input and two outputs; delays from the input to any of the outputs may be matched. In one embodiment, one of the outputs is connected to the input of the successive delay element in the DDL chain 604 and to one of the inputs of the multiplexer 625 that is used to select one of the DLL outputs to generate a TX carrier signal having a desired duty cycle. The second output is directed to a D input of one of a chain of TDC flip-flops 703 that collectively provide the lower 24 bits of the output of the TDC 602. The flip-flops 703 are clocked on the rising edge of the signal CLKREFB that itself is an inverted copy of the signal UNDELAYED _REF. As such, each input of each of the flip-flops 703 is captured on the falling edge of signal UNDELAYED _REF. As the signal UNDELAYED_REF propagates through delay elements 605, it reaches the condition where a setup HIGH time violation will occur at some flip-flop, where all downstream flip-flops capturing outputs of delay elements 605 will capture logic value LOW and all upstream flip-flops flop will capture logic value HI. The captured logic values in all flip-flops 703 then form the digtal signal TDCOUT of length N.

The minimally supported duty cycle may depend on the period of the TX carrier; that period, however, is generally limited by the shortest controlled pulse width for any operating condition. This limit is set by a mismatch in the signal paths of two PA drivers as well as any variation in propagation delays for the pull-up and pull-down drivers that reduce the accuracy of the DCC circuitry 600. This limitation thus results in reduced control over the range of the duty cycle at a lower TX carrier frequency. Accordingly, while the duty cycle control is optimal for the NMR application (or any suitable application), implementing this feature may result in either reduced accuracy in determining the desired duty cycle of the TX carrier at higher frequencies or a reduced control range of the duty cycle at lower frequencies. This can be mitigated by choosing a smaller unit delay Td and/or a larger number of DDL delay elements N.

In various embodiments, a smaller amount of power may be required for excitation of a sample at a lower TX carrier frequency. The availability of the low-power mode with a 25% duty cycle and below the control range may address this requirement. At a higher frequency, more power is required and a TX carrier having a 50% duty cycle is used almost exclusively.

In sum, various embodiments of the present invention provide an all-digital, on-chip duty-cycle control mechanism for accurately setting the duty cycle of PA switching waveforms; this ensures power control with predictable accuracy.

The central processing unit of the processor block 640 may be a general-purpose processor and, in some embodiments, may be implemented in the controller 110. Alternatively, the central processing unit of the processor block 640 may utilize any of a wide variety of other technologies including special-purpose hardware, a microcomputer, minicomputer, mainframe computer, programmed microprocessor, microcontroller, peripheral integrated circuit element, a CSIC (customer-specific integrated circuit), ASIC (application-specific integrated circuit), a logic circuit, a digital signal processor, a programmable logic device such as an FPGA (field-programmable gate array), PLD (programmable logic device), PLA (programmable logic array), RFID processor, smart chip, or any other device or arrangement of devices that is capable of implementing the steps of the processes of the invention.

The terms and expressions employed herein are used as terms and expressions of description and not of limitation, and there is no intention, in the use of such terms and expressions, of excluding any equivalents of the features shown and described or portions thereof. In addition, having described certain embodiments of the invention, it will be apparent to those of ordinary skill in the art that other embodiments incorporating the concepts disclosed herein may be used without departing from the scope of the invention as defined by the claims. Accordingly, the described embodiments are to be considered in all respects as only illustrative and not restrictive.

## Claims

1. Circuitry (600) for adjusting a duty cycle of an RF carrier input signal to a power amplifier (PA), the circuitry comprising:

   a time-to-digital converter comprising a digital delay line (604) and a time-to-digital converter logic block (602), the digital delay line (604) for receiving the input signal and comprising a plurality of digital delay elements (605) connected in series, wherein the time-to-digital converter is configured to measure the period of the input signal expressed as a number of the digital delay elements;
   circuitry (625, 628) for selecting a number of delay elements of the digital delay line required to generate an output signal with a desired duty cycle, and for generating the output signal by combining the input signal with a delayed input signal via a logical AND operation, wherein the delayed input signal is generated by the selected number of delay elements; and
   a processor having a control register (620) for enabling a HIGH-power mode or a LOW-power mode of the circuitry, wherein the control register is configured to select the HIGH-power mode if the desired duty cycle has a value between 25% and 50% and the LOW-power mode if the desired duty cycle has a value between 5% and 25%.

2. The circuitry of claim 1, wherein the control register has a value of 1 for enabling the LOW-power mode and a value of 0 for enabling the HIGH-power mode.

3. The circuitry of claim 1, wherein the processor further comprises a register (620) for bypassing the digital delay line.

4. The circuitry of claim 1, wherein each one of the delay elements comprises one input and three outputs.

5. The circuitry of claim 4, wherein a first one of the outputs is coupled to an input of a successive delay element; a second one of the outputs is coupled to an input of a multiplexer (608); and a third one of the outputs is coupled to an input of the time-to-digital converter.

6. The circuitry of claim 1, wherein the processor (640) is configured to determine the number of the delay elements required for generating the desired duty cycle based on a measurement of the time-to-digital converter.

7. The circuitry of claim 6, wherein the processor is implemented on a chip integrating the digital delay line and time-to-digital converter.

8. The circuitry of claim 6, wherein the processor is implemented off a chip integrating the digital delay line and time-to-digital converter, and wherein the circuitry further comprises a communication module for allowing signal communication between the processor and the chip.

9. An Nuclear magnetic resonance, NMR, apparatus comprising:

an NMR coil configured to enclose a sample;
an integrated switch-mode power amplifier coupled to the NMR coil; and
circuitry in accordance with any of the preceding claims for adjusting a duty cycle of an input signal to the power amplifier.

**Patentansprüche**

1. Schaltungen (600) zum Anpassen eines Tastverhältnisses eines HF-Träger-Eingangssignals an einen Leistungsverstärker (PA), wobei die Schaltungen Folgendes umfassen:

einen Zeit-Digital-Wandler, der eine digitale Verzögerungsleitung (604) und einen Zeit-Digital-Wandler-Logikblock (602) umfasst, wobei die digitale Verzögerungsleitung (604) zum Empfangen des Eingangssignals dient und eine Vielzahl von in Reihe geschalteten digitalen Verzögerungselementen (605) umfasst, wobei der Zeit-Digital-Wandler dafür konfiguriert ist, die Periode des Eingangssignals zu messen, die als eine Anzahl der digitalen Verzögerungselemente ausgedrückt wird;
Schaltungen (625, 628) zum Auswählen einer Anzahl von Verzögerungselementen der digitalen Verzögerungsleitung, die erforderlich sind, um ein Ausgangssignal mit einem erwünschten Tastverhältnis zu erzeugen, und zum Erzeugen des Ausgangssignals durch Kombinieren des Eingangssignals mit einem verzögerten Eingangssignal mittels einer logischen UND-Operation, wobei das verzögerte Eingangssignal durch die ausgewählte Anzahl von Verzögerungselementen erzeugt wird; und
einen Prozessor mit einem Steuerregister (620) zum Aktivieren eines Hochleistungsmodus oder eines Stromsparmodus der Schaltungen, wobei das Steuerregister dafür konfiguriert ist, den Hochleistungsmodus auszuwählen, wenn das erwünschte Tastverhältnis einen Wert zwischen 25 % und 50 % aufweist, und den Stromsparmodus auszuwählen, wenn das erwünschte Tastverhältnis einen Wert zwischen 5 % und 25 % aufweist.

2. Schaltungen nach Anspruch 1, wobei das Steuerregister einen Wert von 1 zum Aktivieren des Stromsparmodus und einen Wert von 0 zum Aktivieren des Hochleistungsmodus aufweist.

3. Schaltungen nach Anspruch 1, wobei der Prozessor ferner ein Register (620) zum Umgehen der digitalen Verzögerungsleitung umfasst.

4. Schaltungen nach Anspruch 1, wobei jedes der Verzögerungselemente einen Eingang und drei Ausgänge umfasst.

5. Schaltungen nach Anspruch 4, wobei ein erster der Ausgänge mit einem Eingang eines nachfolgenden Verzögerungselements gekoppelt ist; ein zweiter der Ausgänge mit einem Eingang eines Multiplexers (608) gekoppelt ist; und ein dritter der Ausgänge mit einem Eingang des Zeit-Digital-Wandlers gekoppelt ist.

6. Schaltungen nach Anspruch 1, wobei der Prozessor (640) dafür konfiguriert ist, die Anzahl der Verzögerungselemente, die zum Erzeugen des erwünschten Tastverhältnisses erforderlich sind, auf der Grundlage einer Messung des Zeit-Digital-Wandlers zu bestimmen.

7. Schaltungen nach Anspruch 6, wobei der Prozessor auf einem Chip implementiert ist, der die digitale Verzögerungsleitung und den Zeit-Digital-Wandler integriert.

8. Schaltungen nach Anspruch 6, wobei der Prozessor außerhalb eines Chips implementiert ist, der die digitale Verzögerungsleitung und den Zeit-Digital-Wandler integriert, und wobei die Schaltungen ferner ein Kommunikationsmodul zum Ermöglichen einer Signalkommunikation zwischen dem Prozessor und dem Chip umfassen.

9. Kernspinresonanz(NMR)-Vorrichtung, umfassend:

eine NMR-Spule, die dafür konfiguriert ist, eine Probe zu umschließen;
einen integrierten Schaltmodus-Leistungsverstärker, der mit der NMR-Spule gekoppelt ist; und
Schaltungen nach einem der vorhergehenden Ansprüche zum Anpassen eines Tastverhältnisses eines Eingangssignals an den Leistungsverstärker.

**Revendications**

1. Circuits (600) permettant d'ajuster un rapport cyclique d'un signal d'entrée de porteuse de RF à un amplificateur de puissance (PA), les circuits comprenant :

   un convertisseur temps-numérique comprenant une ligne de retard numérique (604) et un bloc logique de convertisseur temps-numérique (602), la ligne de retard numérique (604) permettant de recevoir le signal d'entrée et comprenant une pluralité d'éléments de retard numérique (605) connectés en série, dans lesquels le convertisseur temps-numérique est configuré pour mesurer la période du signal d'entrée exprimée comme un nombre d'éléments de retard numérique ;
   des circuits (625, 628) permettant de sélectionner un nombre d'éléments de retard de la ligne de retard numérique requis pour générer un signal de sortie avec un rapport cyclique souhaité, et pour générer le signal de sortie en combinant le signal d'entrée avec un signal d'entrée retardé par le biais d'une opération ET logique, dans lesquels le signal d'entrée retardé est généré par le nombre sélectionné d'éléments de retard ; et
   un processeur présentant un registre de commande (620) permettant d'activer un mode HAUTE puissance ou un mode BASSE puissance des circuits, dans lesquels le registre de commande est configuré pour sélectionner le mode HAUTE puissance si le rapport cyclique souhaité présente une valeur comprise entre 25 % et 50 % et le mode BASSE puissance si le rapport cyclique souhaité présente une valeur comprise entre 5 % et 25 %.

2. Circuits selon la revendication 1, dans lesquels le registre de commande présente une valeur de 1 permettant d'activer le mode BASSE puissance et une valeur de 0 permettant d'activer le mode HAUTE puissance.

3. Circuits selon la revendication 1, dans lesquels le processeur comprend en outre un registre (620) permettant de contourner la ligne de retard numérique.

4. Circuits selon la revendication 1, dans lesquels chacun des éléments de retard comprend une entrée et trois sorties.

5. Circuits selon la revendication 4, dans lesquels une première parmi les sorties est couplée à une entrée d'un élément de retard successif ; une deuxième parmi les sorties est couplée à une entrée d'un multiplexeur (608) ; et une troisième parmi les sorties est couplée à une entrée du convertisseur temps-numérique.

6. Circuits selon la revendication 1, dans lesquels le processeur (640) est configuré pour déterminer le nombre des éléments de retard requis pour générer le rapport cyclique souhaité, sur la base d'une mesure du convertisseur temps-numérique.

7. Circuits selon la revendication 6, dans lesquels le processeur est mis en œuvre sur une puce intégrant la ligne de retard numérique et le convertisseur temps-numérique.

8. Circuits selon la revendication 6, dans lesquels le processeur est mis en œuvre hors d'une puce intégrant la ligne de retard numérique et un convertisseur temps-numérique, et dans lesquels le circuit comprennent en outre un module de communication pour permettre une communication de signal entre le processeur et la puce.

9. Appareil à résonance magnétique nucléaire, RMN, comprenant :

   une bobine RMN configurée pour envelopper un échantillon ;
   un amplificateur de puissance en mode commutation intégré couplé à la bobine RMN ; et
   des circuits selon l'une quelconque des revendications précédentes permettant d'ajuster un rapport cyclique d'un signal d'entrée à l'amplificateur de puissance.

FIG. 1
(PRIOR ART)

VDDPA

204

200

V_S

R_OUT

202

R_L 206

VSSPA

VSSPA

## FIG. 2A
## (PRIOR ART)

DUTY CYCLE 50%

Tpw

VDDPA

t

-VDDPA

Tper

DUTY CYCLE 25%

Tpw

VDDPA

t

-VDDPA

Tper

DC = Tper/Tpw

## FIG. 2B

FIG. 3A

FIG. 3B

EP 3 602 779 B1

FIG. 4

500

START
PA CALIBRATION

502 — ENABLE
PA CALIBRATION
SENSE CIRCUIT

504 — DISABLE PULL-DOWN
LEG OF PA SENSE CIRCUIT,
SET COMPARATOR
REFERENCE TO
(2/3) VDDPA

506 — SELECT 0 STRIPES OF
PMOS SENSE CIRCUITS

COMPARATOR
OUTPUT — HI → IS THIS FIRST STEP OF THE LOOP — YES → ERROR CONDITION

LO

508 — INCREMENT NUMBER OF
SELECTED PMOS STRIPES BY 1

IS THIS FIRST STEP OF THE LOOP — NO →

510 — WRITE VALUE FOR THE
NUMBER OF STRIPES
OF PMOS CIRCUIT TO
SPI REGISTER

512 — DISABLE PULL-UP LEG
OF PA SENSE CIRCUIT,
ENABLE PULL-DOWN
LEG OF PA SENSE CIRCUIT,
SET COMPARATOR
REFERENCE TO
(1/3) VDDPA

514 — SELECT 15 STRIPES
(ALL) OF NMOS SENSE
CIRCUITS

COMPARATOR
OUTPUT — HI → IS THIS FIRST STEP OF THE LOOP — YES → ERROR CONDITION

LO

516 — DECREMENT NUMBER
OF SELECTED NMOS
STRIPES BY 1

NO

518 — WRITE VALUE FOR THE
NUMBER OF STRIPES
OF NMOS CIRCUIT TO
SPI REGISTER

END
PA CALIBRATION

FIG. 5

FIG. 6A

FIG. 6C

EP 3 602 779 B1

FIG. 6B

FIG. 7

EP 3 602 779 B1

FIG. 8

CKIN_PH0
CKIN_PH90
CK_PH0_DC25
CK_PH90_DC25
SEL_DCC_CK
DCC_MEASURE
DCC_MEASURE_START
DCC_CK_IN
DCC_CAPTRUE
DELAY_LENGTH [23:0]
SELDELAY [4:0]

CLOCK PULSE USED TO
MEASURE CLOCK PERIOD

6'h000000
5'b00000

6'h{MEASURED_DELAY}
5'b{DELAY_VALUE}

DCC PROGRAMMING OPERATION 1
DCC PROGRAMMING OPERATION 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62477009
- US 62477014 B
- US 20120214433 A
- JP H11031952 B
- EP 2383893 A2